# EUROPÄISCHE PATENTSCHRIFT

(11) **EP 3 600 943 B1**
(45) Veröffentlichungstag und Bekanntmachung des Hinweises auf die Patenterteilung: **17.11.2021**
(21) Anmeldenummer: 18712846.7
(22) Anmeldetag: 16.03.2018
(51) Int. Cl.: B60L 3/00, H02M 3/335, B60L 3/04, H02J 7/34, H01H 47/00

(54) **GLEICHSPANNUNGSKONVERTER, SPANNUNGSVERSORGUNGSEINRICHTUNG UND DIAGNOSEVERFAHREN FÜR EINEN GLEICHSPANNUNGSKONVERTER**
DC-TO-DC VOLTAGE CONVERTER, VOLTAGE SUPPLY DEVICE, AND DIAGNOSTIC METHOD FOR A DC-TO-DC VOLTAGE CONVERTER
CONVERTISSEUR CONTINU-CONTINU, DISPOSITIF D'ALIMENTATION ÉLECTRIQUE ET PROCÉDÉ DE DIAGNOSTIC POUR CONVERTISSEUR CONTINU-CONTINU

(30) Priorität: 31.03.2017 DE 102017205481
(43) Veröffentlichungstag der Anmeldung: 05.02.2020
(73) Patentinhaber: Robert Bosch GmbH, 70442 Stuttgart (DE)
(72) Erfinder: JIN, Jiahang, 70806 Kornwestheim (DE)
(86) Internationale Anmeldenummer: PCT/EP2018/056629
(87) Internationale Veröffentlichungsnummer: WO 2018/177772

(56) Entgegenhaltungen:
- JP-A- 2000 278 802
- JP-A- 2011 188 713

## Beschreibung

Die vorliegende Erfindung betrifft ein Diagnoseverfahren für einen Gleichspannungskonverter, einen Gleichspannungskonverter und eine Spannungsversorgungseinrichtung mit einem Gleichspannungskonverter. Insbesondere betrifft die vorliegende Erfindung die Diagnose von bidirektionalen Gleichspannungskonvertern.

### Stand der Technik

Die Druckschrift DE 10 2014 016 076 A1 offenbart einen Gleichspannungswandler für ein Kraftfahrzeug, das einen Hochvoltstromkreis mit einer variablen Hoch- oder Gleichspannung und einen Niedervoltstromkreis mit einer Niedervolt-Gleichspannung umfasst. Hochvoltstromkreis und Niedervoltstromkreis werden über den Gleichspannungswandler miteinander gekoppelt. Die Druckschrift JP 2000 278802 A offenbart ein Diagnoseverfahren für einen Konverter.

Bei Kraftfahrzeugen mit Elektro- oder Hybridantrieb wird die elektrische Energie für den elektrischen Antrieb von einer Hochvoltbatterie bereitgestellt. Gleichzeitig weisen viele Kraftfahrzeuge elektrische Geräte auf, die konstante Niedervoltspannungen benötigen. Dabei sind die Hochvoltspannungen des elektrischen Antriebssystems im Allgemeinen deutlich höher als die Niedervoltspannungen der weiteren elektrischen Verbraucher. Um die Niedervoltgeräte ebenfalls mit Energie aus dem Hochvoltnetz zu versorgen und gegebenenfalls auch eine Batterie auf der Niedervoltseite aufzuladen, wird daher eine Schaltungsanordnung verwendet, welche eine elektrische Energieübertragung zwischen Hochvoltseite und Niedervoltseite ermöglicht.

Für einen ordnungsgemäßen Betrieb eines solchen Gleichspannungswandlers, wie er zum Beispiel zwischen einer Hochvoltseite und einer Niedervoltseite eines Elektro- oder Hybridfahrzeugs eingesetzt wird, sollte sichergestellt werden, dass die Bauelemente dieses Gleichspannungswandlers, insbesondere die dabei verwendeten Schaltelemente, ordnungsgemäß funktionieren.

### Offenbarung der Erfindung

Die vorliegende Erfindung offenbart ein Diagnoseverfahren für einen bidirektionalen Gleichspannungskonverter mit den Merkmalen des Patentanspruchs 1, einen Gleichspannungskonverter mit den Merkmalen des Patentanspruchs 7 und eine Spannungsversorgungseinrichtung für ein Elektro- oder Hybridfahrzeug mit den Merkmalen des Patentanspruchs 8.

### Demgemäß ist vorgesehen:

Ein Diagnoseverfahren für einen bidirektionalen Gleichspannungskonverter. Der Gleichspannungskonverter weist einen ersten Gleichspannungsanschluss und einen zweiten Gleichspannungsanschluss auf. An dem ersten Gleichspannungsanschluss umfasst der Gleichspannungskonverter einen ersten Kondensator und eine erste Vollbrücke. An dem zweiten Gleichspannungsanschluss umfasst der Gleichspannungskonverter eine zweite Vollbrücke. Die erste Vollbrücke und die zweite Vollbrücke können mittels eines Transformators oder ähnlichem miteinander gekoppelt werden. Die Vollbrücken, insbesondere die erste Vollbrücke, umfassen zwei Halbbrücken mit jeweils einem ersten Schaltelement und einem zweiten Schaltelement. Das Verfahren umfasst die Schritte des Bereitstellens einer ersten Gleichspannung an den zweiten Gleichspannungsanschluss des Gleichspannungskonverters und des Öffnens aller ersten Schaltelemente und aller zweiten Schaltelemente in der ersten Vollbrücke des Gleichspannungskonverters. Weiterhin umfasst das Verfahren einen Schritt zum Aufladen des ersten Kondensators auf eine vorbestimmte erste Prüfspannung. Der erste Kondensator wird hierbei durch Ansteuern der zweiten Vollbrücke auf die vorbestimmte erste Prüfspannung aufgeladen. Daraufhin umfasst das Verfahren einen Schritt zum Schließen eines ersten Schaltelements in der ersten Vollbrücke und des anschließenden Detektierens eines fehlerhaften zweiten Schaltelements, falls die elektrische Spannung über dem ersten Kondensator innerhalb einer vorbestimmten ersten Zeitspanne nach dem Schließen des ersten Schaltelements um mehr als einen vorgegebenen ersten Spannungswert absinkt. Falls ein fehlerhaftes zweites Schaltelement detektiert worden ist, kann das Verfahren gegebenenfalls daraufhin beendet werden. Ferner umfasst das Verfahren einen Schritt zum Öffnen des geschlossenen ersten Schaltelements in der ersten Vollbrücke und einen Schritt zum Schließen eines zweiten Schaltelements in der ersten Vollbrücke. Daraufhin umfasst das Verfahren einen Schritt zum Detektieren eines fehlerhaften ersten Schaltelements, falls die elektrische Spannung über dem ersten Kondensator innerhalb einer vorbestimmten zweiten Zeitspanne nach dem Schließen des zweiten Schaltelements um mehr als einen vorgegebenen zweiten Spannungswert absinkt. Wird weder ein fehlerhaftes erstes Schaltelement noch ein fehlerhaftes zweites Schaltelement detektiert, so können die ersten und zweiten Schaltelemente in der Vollbrücke als fehlerfrei klassifiziert werden.

### Weiterhin ist vorgesehen:

Ein Gleichspannungskonverter für eine bidirektionale Gleichspannungskonvertierung zwischen einem ersten Gleichspannungsanschluss und einem zweiten Gleichspannungsanschluss. Der Gleichspannungskonverter umfasst einen ersten Kondensator, eine erste Vollbrücke, eine zweite Vollbrücke und eine Steuereinrichtung. Die erste Vollbrücke und die zweite Vollbrücke können mittels eines Transformators oder ähnlichem miteinander gekoppelt werden. Der erste Kondensator ist mit dem ersten Gleichspannungsanschluss des Gleichspannungskonverters elektrisch gekoppelt. Die erste Vollbrücke ist ebenfalls mit dem ersten Gleichspannungsanschluss elektrisch gekoppelt. Die erste Vollbrücke umfasst zwei Halbbrücken mit jeweils einem ersten Schaltelement und einem zweiten Schaltelement. Die zweite Vollbrücke ist mit dem zweiten Gleichspannungsanschluss elektrisch gekoppelt. Die Steuereinrichtung ist dazu ausgelegt, die ersten Schaltelemente und die zweiten Schaltelemente in der ersten Vollbrücke zu öffnen und den Kondensator durch Ansteuern der zweiten Vollbrücke auf eine vorbestimmte erste Prüfspannung aufzuladen und anschließend eines der ersten Schaltelemente in der ersten Vollbrücke zu schließen. Weiterhin ist die Steuereinrichtung dazu ausgelegt, ein fehlerhaftes zweites Schaltelement in der ersten Vollbrücke zu detektieren, falls die elektrische Spannung über dem ersten Kondensator innerhalb einer vorbestimmten ersten Zeitspanne nach dem Schließen des ersten Schaltelements um mehr als einen vorgegebenen ersten Spannungswert absinkt. Weiterhin ist die Steuereinrichtung dazu ausgelegt, anschließend das geschlossene erste Schaltelement in der ersten Vollbrücke zu öffnen und ein zweites Schaltelement in der ersten Vollbrücke zu schließen, sowie ein fehlerhaftes erstes Schaltelement zu detektieren, falls die elektrische Spannung über dem ersten Kondensator innerhalb einer vorbestimmten zweiten Zeitspanne nach dem Schließen des zweiten Schaltelements um mehr als einen vorgegebenen zweiten Spannungswert absinkt. Sollte zuvor bereits ein fehlerhaftes zweites Schaltelement detektiert worden sein, so kann das Detektieren eines fehlerhaften ersten Schaltelements sowie das vorherige Öffnen des ersten Schaltelements und das Schließen des zweiten Schaltelements übersprungen werden.

### Ferner ist vorgesehen:

Eine Spannungsversorgungseinrichtung für ein Elektro- oder Hybridfahrzeug mit einem Hochvolt-Bordnetz, einem Niedervolt-Bordnetz und einem erfindungsgemäßen Gleichspannungskonverter. Das Hochvolt-Bordnetz ist dazu ausgelegt, elektrische Energie mit einer ersten vorbestimmten elektrischen Spannung bereitzustellen. Das Niedervolt-Bordnetz ist dazu ausgelegt, elektrische Energie mit einer zweiten vorbestimmten elektrischen Spannung bereitzustellen. Der erste Gleichspannungsanschluss des Gleichspannungskonverters ist mit dem Hochvolt-Bordnetz elektrisch koppelbar. Der zweite Gleichspannungsanschluss des Gleichspannungskonverters ist elektrisch mit dem Niedervolt-Bordnetz gekoppelt. Insbesondere kann es sich beim dem Hochvolt-Bordnetz um ein Bordnetz zur Spannungsversorgung eines elektrischen Antriebssystems in dem Elektro- oder Hybridfahrzeug handeln. Bei dem Niedervolt-Bordnetz kann es sich um ein Bordnetz zur Versorgung elektrischer Verbraucher handeln. Das Niedervolt-Bordnetz kann insbesondere im Bereich von 12 Volt, 24 Volt oder 48 Volt betrieben werden.

### Vorteile der Erfindung

Der vorliegenden Erfindung liegt die Erkenntnis zugrunde, dass ein fehlerhaftes Schaltelement in einem Gleichspannungskonverter, insbesondere auf einer Hochvoltseite eines Gleichspannungskonverters gegebenenfalls keine zuverlässige elektrische Trennung ermöglichen kann. In diesem Fall bleibt eine elektrische Verbindung zwischen den Anschlüssen des Schaltelements auch dann zumindest teilweise aufrechterhalten, wenn das Schaltelement geöffnet sein sollte. Während des Betriebs des Gleichspannungskonverters kann dabei über ein solches fehlerhaftes Schaltelement eine unerwünschte elektrische Verbindung hergestellt werden, die gegebenenfalls zu einem Kurzschluss führen kann. Durch einen derartigen Kurzschluss können hohe elektrische Ströme fließen, die zu weiteren Beschädigungen und gegebenenfalls zu einem thermischen Ereignis führen können.

Der vorliegenden Erfindung liegt daher die Idee zugrunde, dieser Erkenntnis Rechnung zu tragen und eine Diagnose für die Schaltelemente eines Gleichspannungskonverters, insbesondere für die Schaltelemente auf der Hochvoltseite eines Gleichspannungskonverters bereitzustellen. Wird ein solches fehlerhaftes Schaltelement in dem Gleichspannungskonverter frühzeitig erkannt, so können daraufhin Maßnahmen eingeleitet werden, die weitere gefährliche Betriebszustände, wie zum Beispiel einen Kurzschluss und ein damit verbundenes thermisches Ereignis verhindern können. Auf diese Weise kann die Sicherheit des Gleichspannungskonverters und damit des gesamten Systems gesteigert werden.

Für die Diagnose des Gleichspannungskonverters kann dabei die verwendete elektrische Energie insbesondere so weit begrenzt werden, dass während der Diagnose keine übermäßige Belastung der beteiligten Bauelemente auftritt. Auf diese Weise können fehlerhafte Schaltelemente identifiziert werden, ohne dass dabei weitere Bauelemente mit in Leidenschaft gezogen werden.

Gemäß einer Ausführungsform werden die Schritte des Öffnens des geschlossenen ersten Schaltelements, des Schließens eines geöffneten zweiten Schaltelements und des Detektierens eines fehlerhaften ersten Schaltelements nur dann ausgeführt, falls zuvor kein fehlerhaftes zweites Schaltelement detektiert worden ist. Falls bereits zuvor ein fehlerhaftes zweites Schaltelement bereits detektiert worden ist, so ergibt sich hierdurch, dass ein ordnungsgemäßer Betrieb des Gleichspannungskonverters nicht möglich ist und somit ein fehlerfreier Betrieb des Gleichspannungskonverters nicht ausgeführt werden kann. Daher kann bereits eine Fehlermeldung ausgegeben werden, ohne dass weitere Schritte zur Diagnose ausgeführt werden müssen.

Gemäß einer Ausführungsform umfasst das Verfahren einen Schritt zum Aufladen des ersten Kondensators auf eine vorbestimmte zweite Spannung, nachdem das geschlossene erste Schaltelement geöffnet worden ist. Insbesondere kann die vorbestimmte zweite Spannung beispielsweise der vorbestimmten ersten Spannung entsprechen. Auf diese Weise kann auch nach der Überprüfung der zweiten Schaltelemente der erste Kondensator erneut auf eine elektrische Spannung aufgeladen werden, die eine zuverlässige Überprüfung der ersten Schaltelemente ermöglicht. Gegebenenfalls kann das Aufladen des ersten Kondensators nach der Überprüfung der zweiten Schaltelemente nur dann ausgeführt werden, falls die elektrische Spannung über dem ersten Kondensator einen vorgegebenen Grenzwert unterschritten hat.

Gemäß einer Ausführungsform werden die vorbestimmte erste Spannung und/oder gegebenenfalls auch die vorbestimmte zweite Spannung, auf die der erste Kondensator aufgeladen wird, in Abhängigkeit von einem maximalen Durchlassstrom, einer maximalen Betriebstemperatur und/oder einer maximalen Wärmedissipation der ersten Schaltelemente und/oder der zweiten Schaltelemente bestimmt. Auf diese Weise kann sichergestellt werden, dass die Schaltelemente während der Überprüfung auch in einem Fehlerfall nicht überlastet werden. Hierdurch kann eine mögliche Beschädigung weiterer Bauelemente verhindert werden.

Gemäß einer Ausführungsform ist der Wert der ersten Prüfspannung, auf die der erste Kondensator vor der Überprüfung der Schaltelemente aufgeladen wird, größer als der Wert der ersten Gleichspannung, die an dem zweiten Gleichspannungsanschluss bereitgestellt wird. Auf diese Weise können die Schaltelemente auf der Hochvoltseite des Gleichspannungskonverters durch das Bereitstellen einer geringeren Spannung auf der Niedervoltseite des Gleichspannungskonverters überprüft werden. Die elektrische Spannung, auf die der erste Kondensator dabei aufgeladen wird, kann beispielsweise einer elektrischen Spannung entsprechen, welche in einem Gleichspanungsnetz anliegt, mit welchem der Gleichspannungskonverter an dem ersten Gleichspannungsanschluss koppelbar ist. Alternativ kann die elektrische Spannung, auf die der erste Kondensator aufgeladen wird auch niedriger sein, als die elektrische Spannung des Gleichspannungsnetzes, mit dem der erste Gleichspannungsanschluss koppelbar ist.

Gemäß einer Ausführungsform umfasst das Verfahren einen Schritt zum Freigeben des Gleichspannungskonverters, falls kein fehlerhaftes erstes Schaltelement und kein fehlerhaftes zweites Schaltelement detektiert worden ist. Auf diese Weise kann sichergestellt werden, dass der Gleichspannungskonverter nur dann betrieben wird, wenn zuvor eine Überprüfung der Schaltelemente in dem Gleichspannungskonverter ausgeführt worden ist.

Erfindungsgemäß umfasst der Gleichspannungskonverter einen Transformator. Der Transformator ist mit einer Primärseite mit der ersten Vollbrücke elektrisch gekoppelt und mit einer Sekundärseite mit der zweiten Vollbrücke elektrisch gekoppelt. Auf diese Weise kann eine galvanische Trennung zwischen der ersten Vollbrücke und der zweiten Vollbrücke erreicht werden. Darüber hinaus kann gegebenenfalls entsprechend dem Übertragungsverhältnis des Transformators die Spannungshöhe während der Gleichspannungswandlung eingestellt werden.

Bei den Schaltelementen des Wechselrichters kann es sich insbesondere beispielsweise um Halbleiterschaltelemente, wie zum Beispiel bipolare Transistoren mit einem isolierten Gateanschluss (IGBT) oder MOSFET handeln.

Die obigen Ausgestaltungen und Weiterbildungen lassen sich, soweit sinnvoll, beliebig miteinander kombinieren. Weitere Ausgestaltungen, Weiterbildungen und Implementierungen der Erfindung umfassen auch nicht explizit genannte Kombinationen von zuvor oder im Folgenden bezüglich den Ausführungsbeispielen beschriebenen Merkmalen der Erfindung.

### Kurze Beschreibung der Zeichnungen

Die vorliegende Erfindung wird nachfolgend anhand der in den schematischen Figuren der Zeichnungen angegebenen Ausführungsbeispiele näher erläutert Dabei zeigen:
- Fig. 1:: eine schematische Darstellung eines Gleichspannungskonverters gemäß einer Ausführungsform;
- Fig. 2:: eine schematische Darstellung eines Spannungs-Zeitdiagramms für den Spannungsverlauf während einer Diagnose eines Gleichspannungskonverters gemäß einer Ausführungsform; und
- Fig. 3:: eine schematische Darstellung eines Ablaufdiagramms, wie es einem Diagnoseverfahren für einen Gleichspannungskonverters gemäß einer Ausführungsform zugrunde liegt.

### Ausführungsformen der Erfindung

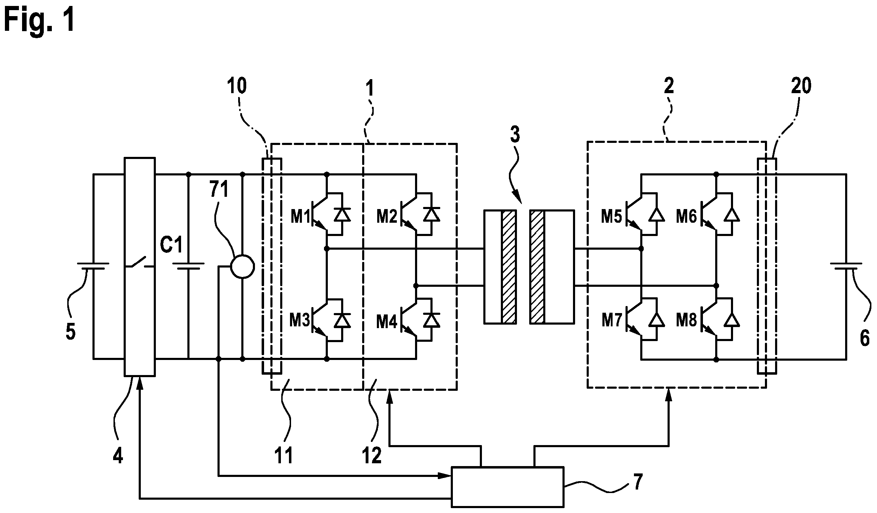

Figur 1 zeigt eine schematische Darstellung eines Gleichspannungswandlers gemäß einer Ausführungsform. Bei dem Gleichspannungswandler handelt es sich insbesondere um einen bidirektionalen Gleichspannungswandler, das heißt der Gleichspannungswandler kann wahlweise eine elektrische Spannung in die eine oder andere Richtung konvertieren.

Der Gleichspannungswandler ist an einem ersten Gleichspannungsanschluss 10 mit einem ersten Gleichspannungsnetz elektrisch verbindbar. Bei diesem ersten Gleichspannungsnetz kann es sich beispielsweise um ein Hochvolt-Bordnetz eines Elektro- oder Hybridfahrzeugs handeln. In der hier dargestellten Ausführungsform ist das erste Gleichspannungsnetz beispielhaft durch eine erste Gleichspannungsquelle 5 dargestellt, die über einen Trennschalter 4 mit dem ersten Gleichspannungsanschluss 10 des Gleichspannungskonverters verbunden ist. An dem ersten Gleichspannungsanschluss 10 ist ein erster Kondensator C1 und eine erste Vollbrücke 1 angeschlossen. Die erste Vollbrücke 1 umfasst in der hier dargestellten Ausführungsform zwei Halbbrücken 11 und 12. Die erste Halbbrücke 11 weist ein oberes Schaltelement M1 und ein unteres Schaltelement M3 auf. Ebenso weist die zweite Halbbrücke 12 ein oberes Schaltelement M2 und ein unteres Schaltelement M4 auf. Die oberen Schaltelemente M1 und M2 sind hier beispielsweise mit dem positiven Anschlusselement des Gleichspannungsanschlusses 10 verbunden. Die unteren Schaltelemente M3 und M4 sind entsprechend mit dem negativen Anschlusselement des ersten Gleichspannungsanschlusses 10 verbunden. Die Verbindungsknoten zwischen den oberen Schaltelementen M1 und M2 sowie den unteren Schaltelementen M3 und M4 sind mit einer Seite, beispielsweise der Primärseite, eines Transformators 3 verbunden.

Weiterhin umfasst der Gleichspannungskonverter eine zweite Vollbrücke 2, die gegebenenfalls gemeinsam mit einem zweiten Kondensator C2 an einem zweiten Gleichspannungsanschluss 20 angeschlossen sind. Dieser zweite Gleichspannungsanschluss 20 kann mit einem weiteren Gleichspannungsnetz, beispielsweise einem Niedervolt-Bordnetz eines Elektro- oder Hybridfahrzeuges verbunden sein. Dieses zweite Gleichspannungsnetz ist hier exemplarisch durch die zweite Gleichspannungsquelle 6 dargestellt. Analog zu der ersten Vollbrücke 1 ist die zweite Vollbrücke 2 mit einer weiteren Seite des Transformators 3, beispielsweise einer Sekundärseite des Transformators 3 verbunden. Die Ansteuerung des Gleichspannungswandlers, insbesondere die Ansteuerung der Schaltelemente in der ersten Vollbrücke 1 und der zweiten Vollbrücke 2 erfolgt mittels einer Steuereinrichtung 7.

Um sicherzustellen, dass während des Betriebs des Gleichspannungswandlers die Schaltelemente M1 bis M4 der ersten Vollbrücke 1 eine ordnungsgemäße elektrische Trennung gewährleisten können, kann eine Diagnose der Schaltelemente M1 bis M4 ausgeführt werden. Hierzu kann beispielsweise mittels eines Spannungssensors 71 eine elektrische Spannung über dem ersten Kondensator C1 erfasst werden. Durch Aufladen des ersten Kondensats C1 auf eine vorgegebene Prüfspannung und anschließendes Einstellen von vorgegebenen Schaltzuständen in der ersten Vollbrücke 1 kann aus dem Spannungsverlauf über dem ersten Kondensator C1 eine Aussage über die Funktionsfähigkeit der Schaltelemente M1 bis M4 der ersten Vollbrücke 1 getroffen werden.

Im Folgenden wir der Ablauf der Diagnose der Schaltelemente M1 bis M4 in der ersten Vollbrücke 1 beschrieben.

Während der Diagnose der Schaltelemente M1 bis M4 in der ersten Vollbrücke 1 ist der Gleichspannungskonverter an dem zweiten Gleichspannungsanschluss 20 mit einer Spannungsquelle 6, beispielsweise einem Niedervolt-Bordnetz eines Fahrzeugs elektrisch verbunden. Weiterhin ist der erste Gleichspannungsanschluss 10 von weiteren elektrischen Verbrauchern entkoppelt. Beispielsweise kann der Trennschalter 4 geöffnet werden. Hierzu kann zum Beispiel die Steuereinrichtung 7 ein entsprechendes Ansteuersignal an dem Trennschalter 4 bereitstellen.

Weiterhin werden die Schaltelemente M1 bis M4 mit den Halbbrücken 11 und 12 der ersten Vollbrücke 1 durch eine entsprechende Ansteuerung, beispielsweise mittels Ansteuersignalen der Steuereinrichtung 7, geöffnet.

Anschließend wird die zweite Vollbrücke 2, insbesondere die Schaltelemente M5 bis M8 der zweiten Vollbrücke 2, durch die Steuereinrichtung 7 angesteuert. Hierdurch wird an der Sekundärseite des Transformators 3 eine Wechselspannung bereitgestellt. Die daraufhin an der Primärseite des Transformators 3 induzierte Wechselspannung wird über die parallel zu den Schaltelementen M1 bis M4 der ersten Vollbrücke 1 angeordneten Dioden gleichgerichtet und lädt daraufhin den ersten Kondensator C1 auf. Durch ein geeignetes Ansteuern der Schaltelemente M5 bis M8 in der zweiten Vollbrücke 2 kann auf diese Weise der erste Kondensator C1 auf eine vorgegebene Prüfspannung Up aufgeladen werden.

Nachdem der ersten Kondensator C1 auf die vorgegebene Prüfspannung Up aufgeladen worden ist, wird die Ansteuerung der zweiten Vollbrücke 2 beendet. Anschließend wird ein oberes Schaltelement M1 oder M2 in einer der beiden Halbbrücken 11 oder 12 geschlossen, während die übrigen drei Schaltelemente geöffnet bleiben. Beispielsweise kann das erste Schaltelement M1 geschlossen werden, während die Schaltelemente M2 bis M4 geöffnet bleiben.

Können die unteren Schaltelemente M3 und M4 in den Halbbrücken 11 und 12 der ersten Vollbrücke 1 in diesem Schaltzustand eine ausreichende Isolation gewährleisten, so wird sich der erste Kondensator C1 nicht entladen und die elektrische Spannung über dem ersten Kondensator C1 wird annähernd konstant aufrechterhalten bleiben. Hierzu kann der Spannungsverlauf über dem ersten Kondensator C1 beispielsweise mittels des Spannungssensors 71 erfasst und an der Steuereinrichtung 7 bereitgestellt werden. Bleibt die elektrische Spannung über dem ersten Kondensator C1 während einer vorgegebenen Zeitspanne Δt annähernd konstant, das heißt sinkt die elektrische Spannung über dem ersten Kondensator C1 um weniger als einen vorgegebenen Schwellwert ab, so kann davon ausgegangen werden, dass die unteren Schaltelemente M3 und M4 der beiden Halbbrücken 11 und 12 in der ersten Vollbrücke 1 eine ausreichend hohe Isolation gewährleisten können.

Ist dagegen das untere Schaltelement M3 in der Halbbrücke 11 defekt, in welcher das obere Schaltelement M1 gezielt geschlossen worden ist, so wird die elektrische Spannung über dem ersten Kondensator C1 sehr rasch abfallen. In diesem Fall kann durch den Spannungssensor 71 dieser Spannungsabfall detektiert werden.

Befinden sich dagegen das gezielt geschlossene obere Schaltelement M1 und das fehlerhafte untere Schaltelement M4 in unterschiedlichen Halbbrücken 11, 12, so wird sich der erste Kondensator C1 über das gezielt geschlossene Schaltelement M1, die Primärseite des Transformators 3 und das fehlerhafte Schaltelement M4 entladen. In diesem Fall wird sich der erste Kondensator C1 ebenfalls entladen, jedoch langsamer, als in dem Fall, in dem sich das fehlerhafte untere Schaltelement und das gezielt geschlossene obere Schaltelement in der gleichen Halbbrücke befinden. In diesem Fall wird daher die Spannung über dem ersten Kondensator C1 innerhalb einer vorgegebenen Zeitspanne weniger starken absinken.

Entsprechend kann durch Auswertung des Spannungsverlaufs über dem ersten Kondensator C1 festgestellt werden, ob die unteren Schaltelemente M3 und M4 eine ausreichende Trennung in geöffnetem Zustand gewährleisten, oder ob eines der beiden unteren Schaltelemente M3 oder M4 keine ausreichende elektrische Trennung gewährleisten kann. Durch einen Vergleich der elektrischen Spannung über dem ersten Kondensator C1 mit einem ersten vorgegebenen Grenzwert und gegebenenfalls einem zweiten vorgegebenen Grenzwert kann daraufhin ermittelt werden, ob eines der beiden unteren Schaltelemente M3 oder M4 fehlerhaft ist. Gegebenenfalls kann aus der Höhe des Spannungsabfalls innerhalb der vorgegebenen Zeitspanne Δt eine Aussage darüber getroffen werden, welches der beiden Schaltelemente M3 bzw. M4 fehlerhaft ist.

Wird festgestellt, dass eines der beiden unteren Schaltelemente M3 oder M4 fehlerhaft ist, so kann die Diagnose zu diesem Zeitpunkt bereits beendet werden. Andernfalls, oder wenn auch zusätzlich die oberen Schaltelemente M1 und M3 überprüft werden sollen, kann daraufhin eine entsprechende Diagnose für die beiden oberen Schaltelemente M1 und M2 ausgeführt werden.

Hierzu kann gegebenenfalls der erste Kondensator C1 erneut aufgeladen werden. Beispielsweise kann der erste Kondensator C1 durch entsprechendes Ansteuern der Schaltelemente in der zweiten Vollbrücke 2 erneut auf die vorgegebene Prüfspannung Up aufgeladen werden.

Alternativ ist es auch möglich, falls die elektrische Spannung über dem ersten Kondensator C1 sich noch oberhalb eines vorgegebenen Grenzwertes befindet, auf ein erneutes Aufladen des ersten Kondensators C1 zu verzichten und mit der verbleibenden Restspannung in dem Kondensator C1 die weitere Diagnose auszuführen. Unabhängig davon, ob der erste Kondensator C1 erneut aufgeladen worden ist oder nicht, wird für die Diagnose der oberen Schaltelemente M1 und M2 ein unteres Schaltelement M3 oder M4 geschlossen, während alle anderen Schaltelemente geöffnet werden. Beispielsweise kann hierzu das untere Schaltelement M3 in der ersten Halbbrücke 11 geschlossen werden, während die oberen Schaltelemente M1 und M2, sowie das weitere untere Schaltelement M4 geöffnet bleiben.

Daraufhin erfolgt erneut eine Auswertung des Spannungsverlaufs über dem ersten Kondensator C1 während einer vorbestimmten Zeitspanne. Bleibt dabei der Spannungsabfall über dem ersten Kondensator C1 unterhalb eines vorgegebenen Spannungsabfalls, so können auch die oberen Schaltelemente M1 und M2 als funktionsfähig klassifiziert werden. Fällt dagegen die elektrische Spannung über dem ersten Kondensator C1 unterhalb einen vorgegebenen Grenzwert, so ist mindestens eines der beiden oberen Schaltelemente M1 und M2 fehlerhaft. Auch hierbei kann basierend auf der Höhe des Spannungsabfalls über dem ersten Kondensator C1 während der vorbestimmten Zeitspanne darauf geschlossen werden, ob das obere Schaltelement M1, M2 in der gleichen Halbbrücke 11, 12, in der auch das gezielt geschlossene untere Schaltelemente M3, M4 liegt, fehlerhaft ist, oder ob sich das gezielt geschlossene untere Schaltelemente M3, M4 und das fehlerhafte obere Schaltelement M1, M2 in unterschiedlichen Halbbrücken 11, 12 befinden.

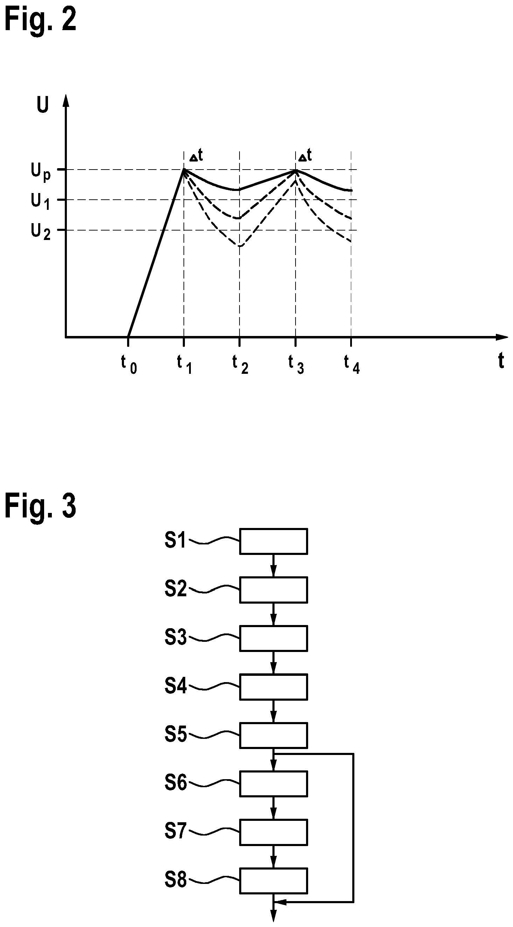

Figur 2 zeigt eine schematische Darstellung eines Spannungs-Zeitveriaufs während einer Diagnose eines Gleichspannungswandlers gemäß einer Ausführungsform. Zum Zeitpunkt t0 wird der Kondensator C1 zunächst auf die vorgegebene Prüfspannung Up aufgeladen. Zum Zeitpunkt t1 erreicht die Spannung über dem ersten Kondensator C1 die vorgegebene Prüfspannung Up. Anschließend wird die Aufladung des ersten Kondensats C1 beendet und der Spannungsverlauf über dem ersten Kondensator C1 überwacht. Liegt nach einer vorgegebenen Zeitspanne Δt zum Zeitpunkt t2 die elektrische Spannung über dem ersten Kondensator C1 noch oberhalb eines vorgegebenen ersten Grenzwertes U1, so können die zu überprüfenden Schaltelemente als intakt klassifiziert werden. Liegt die elektrische Spannung über dem ersten Kondensator C1 unterhalb der ersten vorgegebenen Grenzspannung U1, so ist mindestens eines der zu überprüfenden Schaltelemente fehlerhaft. Sinkt die elektrische Spannung über dem ersten Kondensator C1 dabei gegebenenfalls unterhalb einen vorgegebenen zweiten Spannungswert U2, so ist dies ein Hinweis darauf, dass sich das fehlerhafte Schaltelement und das gezielt geschlossene Schaltelement in derselben Halbbrücke befinden.

Ist kein fehlerhaftes Schaltelement klassifiziert worden, so können daraufhin auch die weiteren Schaltelemente überprüft werden. Wurden beispielsweise zunächst die unteren Schaltelemente M3 und M4 überprüft, so können anschließend die oberen Schaltelemente M1 und M2 überprüft werden. Hierzu kann gegebenenfalls die elektrische Spannung über dem ersten Kondensator C1 erneut auf die Prüfspannung Up aufgeladen werden. Ist dies zum Zeitpunkt t3 erreicht, so wird während einer vorgegebenen Zeitspanne Δt erneut der Spannungsverlauf über dem ersten Kondensator C1 überwacht. Ist die Spannung zum Zeitpunkt t4 noch oberhalb der vorgegebenen Grenzspannung U1, so sind auch die hierbei überprüften Schaltelemente intakt. Ist die Spannung dagegen unterhalb der vorgegebenen Grenzspannung U1 gefallen, so ist mindestens eines der zu überprüfenden Schaltelemente fehlerhaft. Sinkt die Spannung über dem ersten Kondensator C1 dabei unter eine niedrigere zweite Grenzspannung U2, so ist dies erneut ein Hinweis darauf, dass sich das gezielt geschlossene Schaltelement und das fehlerhafte Schaltelement in derselben Halbbrücke befinden.

Figur 3 zeigt eine schematische Darstellung eines Ablaufdiagramms, wie es einem Diagnoseverfahren für einen Gleichspannungskonverter gemäß einer Ausführungsform zugrunde liegt. Das hier nachfolgend beschriebene Diagnoseverfahren entspricht in Wesentlichen der Diagnose, wie sie zuvor bereits beschrieben worden ist.

In Schritt S1 wird zunächst eine erste Gleichspannung an dem zweiten Gleichspannungsanschluss 20 des Gleichspannungskonverters bereitgestellt und in Schritt S2 werden sämtliche erste Schaltelemente M1, M2 und zweite Schaltelemente M3, M4 in der ersten Vollbrücke 1 des Gleichspannungskonverters geöffnet. In Schritt S3 wird daraufhin der erste Kondensator C1 auf eine vorbestimmte Prüfspannung Up durch Ansteuern der zweiten Vollbrücke 2 aufgeladen. Anschließend wird in Schritt S4 eines der ersten Schaltelemente M1, M2 in der ersten Vollbrücke 1 geschlossen. Falls die elektrische Spannung über dem ersten Kondensator C1 innerhalb einer vorbestimmten ersten Zeitspanne Δt nach dem Schließen des ersten Schaltelements M1, M2 um mehr als einen vorgegebenen ersten Spannungswert absinkt, so kann in Schritt S5 ein fehlerhaftes zweites Schaltelement detektiert werden. In diesem Fall kann das Verfahren beendet werden, da bereits ein fehlerhaftes Schaltelement detektiert worden ist.

Ist kein fehlerhaftes zweites Schaltelement M3, M4 detektiert worden, oder sollen trotz einem fehlerhaften zweiten Schaltelement M3, M4 auch die ersten Schaltelemente M1, M2 überprüft werden, so wird in Schritt S6 das geschlossene erste Schaltelement M1, M2 der ersten Vollbrücke 1 geöffnet und ein zweites Schaltelement M3 oder M4 in der ersten Vollbrücke 1 geschlossen. Falls daraufhin die elektrische Spannung über dem ersten Kondensator C1 innerhalb einer vorbestimmten zweiten Zeitspanne nach dem Schließen des zweiten Schaltelements M3 oder M4 in Schritt S7 um mehr als einen vorgegebenen Spannungswert absinkt, so kann hierdurch in Schritt S8 ein fehlerhaftes erstes Schaltelement M1, M2 detektiert werden.

Zum Schutz der Bauelemente in dem Gleichspannungskonverter kann die elektrische Spannung, auf die der erste Kondensator C1 aufgeladen wird, begrenzt werden. Insbesondere kann die maximale elektrische Spannung, auf die der erste Kondensator C1 aufgeladen wird, in Abhängigkeit von einem maximal zulässigen Durchlassstrom der Schaltelemente M1 bis M4 in der ersten Vollbrücke 1, einer maximalen Betriebstemperatur und/oder einer maximalen Wärmedissipation der Schaltelemente M1 bis M4 bestimmt werden.

Zusammenfassend betrifft die vorliegende Erfindung die Diagnose der Schaltelemente in einem bidirektionalen Gleichspannungskonverter. Durch Aufladen eines Kondensators in dem Gleichspannungskonverter und anschließendes gezieltes Ansteuern der Schaltelemente sowie Auswerten der Spannung in dem aufgeladenen Kondensator des Gleichspannungskonverters ist es möglich, ein fehlerhaftes Schaltelement zu identifizieren.

## Patentansprüche

1. Diagnoseverfahren für einen bidirektionalen Gleichspanungskonverter, der an einem ersten Gleichspannungsanschluss (10) einen ersten Kondensator (C1) und eine erste Vollbrücke (1) umfasst und der an einem zweiten Gleichspannungsanschluss (20) eine zweite Vollbrücke (2) umfasst, wobei die erste Vollbrücke (1) zwei Halbbrücken (11, 12) mit jeweils einem ersten Schaltelement (M1, M2) und einem zweiten Schaltelement (M3, M4) umfassen,
wobei der erste Gleichspannungsanschluss 10 von weiteren elektrischen Verbrauchern entkoppelt ist,
wobei der Gleichspannungskonverter einen Transformator (3) umfasst, der mit einer Primärseite mit der ersten Vollbrücke (1) elektrisch gekoppelt ist und mit einer Sekundärseite mit der zweiten Vollbrücke (2) elektrisch gekoppelt ist,
mit den Schritten:
Bereitstellen (S1) einer ersten Gleichspannung an dem zweiten Gleichspannungsanschluss (20) des Gleichspannungskonverters;
Öffnen (S2) der ersten Schaltelemente (M1, M2) und der zweiten Schaltelemente (M3, M4) in der ersten Vollbrücke (1);
Aufladen (S3) des ersten Kondensators (C1) auf eine vorbestimmte erste Prüfspannung durch Ansteuern der zweiten Vollbrücke (2);
Schließen (S4) eines ersten Schaltelements (M1, M2) in der ersten Vollbrücke (1);
Detektieren (S5) eines fehlerhaften zweiten Schaltelements (M3, M4), falls die elektrische Spannung über dem ersten Kondensator (C1) innerhalb einer vorbestimmten ersten Zeitspanne nach dem Schließen des ersten Schaltelements (M1, M2) um mehr als einen vorgegebenen ersten Spannungswert absinkt;
Öffnen (S6) des geschlossenen ersten Schaltelements (M1, M2) in der ersten Vollbrücke (1);
Schließen (S7) eines zweiten Schaltelements (M3, M4) in der ersten Vollbrücke (1); und
Detektieren (S8) eines fehlerhaften ersten Schaltelements (M1, M2), falls die elektrische Spannung über dem ersten Kondensator (C1) innerhalb einer vorbestimmten zweiten Zeitspanne nach dem Schließen des zweiten Schaltelements (M3, M4) um mehr als einen vorgegebenen zweiten Spannungswert absinkt,
**dadurch gekennzeichnet,**
**dass** die zweite Vollbrücke (2) zum Aufladen (S3) des Kondensators (C1) derart angesteuert wird, dass an der Sekundärseite des Transformators (3) eine Wechselspannung bereitgestellt wird und dass eine daraufhin an der Primärseite des Transformators (3) induzierte Wechselspannung über die parallel zu den Schaltelementen (M1.. M4) der ersten Vollbrücke (1) angeordneten Dioden gleichgerichtet wird und den ersten Kondensator (C1) auflädt.

2. Diagnoseverfahren nach Anspruch 1, wobei die Schritte des Öffnens (S6) des geschlossenen ersten Schaltelements (M1, M2), des Schließens (S7) des zweiten Schaltelements (M3, M4) und des Detektierens (S8) eines fehlerhaften ersten Schaltelements (M1, M2) nur ausgeführt werden, falls kein fehlerhaftes zweites Schaltelement (M3, M4) detektiert worden ist.

3. Diagnoseverfahren nach Anspruch 1 oder 2, mit einem Schritt zum Aufladen des ersten Kondensators (C1) auf eine vorbestimmte zweite Prüfspannung, nachdem das geschlossene erste Schaltelement (M1, M2) geöffnet worden ist.

4. Diagnoseverfahren nach einem der Ansprüche 1 bis 3, wobei die vorbestimmte erste Spannung und/oder die vorbestimmte zweite Spannung, auf die der erste Kondensator (C1) aufgeladen wird, in Abhängigkeit von einem maximalen Durchlassstrom, einer maximalen Betriebstemperatur und/oder einer maximalen Wärmedissipation der ersten Schaltelemente (M1, M2) und/oder der zweiten Schaltelemente (M3, M4) in der ersten Vollbrücke (1) bestimmt wird.

5. Diagnoseverfahren nach einem der Ansprüche 1 bis 4, wobei der Wert der ersten Prüfspannung, auf die der erste Kondensator (C1) aufgeladen wird, größer ist, als der Wert der ersten Gleichspannung, die an dem zweiten Gleichspannungsanschluss (20) bereitgestellt wird.

6. Diagnoseverfahren nach einem der Ansprüche 1 bis 5, mit einem Schritt zum Freigeben des Gleichspannungskonverters, falls kein fehlerhaftes erstes Schaltelement (M1, M2) und kein fehlerhaftes zweites Schaltelement (M3, M4) detektiert worden ist.

7. Gleichspanungskonverter, für eine bidirektionale Gleichspannungskonvertierung zwischen einem ersten Gleichspannungsanschluss (10) und einem zweiten Gleichspannungsanschluss (20), mit:
einem Transformator (3), der mit einer Primärseite mit der ersten Vollbrücke (1) elektrisch gekoppelt ist und mit einer Sekundärseite mit der zweiten Vollbrücke (2) elektrisch gekoppelt ist;
einem ersten Kondensator (C1), der mit dem ersten Gleichspannungsanschluss (10) elektrisch gekoppelt ist,
wobei der erste Gleichspannungsanschluss (10) von weiteren elektrischen Verbrauchern entkoppelt ist;
einer ersten Vollbrücke (1), die mit dem ersten Gleichspannungsanschluss (10) elektrisch gekoppelt ist, und die zwei Halbbrücken (11, 12) mit jeweils einem ersten Schaltelement (M1, M2) und einem zweiten Schaltelement (M3, M4) umfasst;
einer zweiten Vollbrücke (2), die mit dem zweiten Gleichspannungsanschluss (20) elektrisch gekoppelt ist; und
einer Steuereinrichtung (7), die dazu ausgelegt ist, die ersten Schaltelemente (M1, M2) und die zweiten Schaltelemente (M3, M4) der ersten Vollbrücke (1) zu öffnen, den ersten Kondensator (C1) durch Ansteuern der zweiten Vollbrücke (2) auf eine vorbestimmte erste Prüfspannung aufzuladen, anschließend eines der ersten Schaltelemente (M1, M2) in der ersten Vollbrücke (1) zu schließen und ein fehlerhaftes zweites Schaltelement (M3, M4) in der ersten Vollbrücke (1) zu detektieren, falls die elektrische Spannung über dem ersten Kondensator (C1) innerhalb einer vorbestimmten ersten Zeitspanne nach dem Schließen des ersten Schaltelements (M1, M2) um mehr als einen vorgegebenen ersten Spannungswert absinkt, anschließend das geschlossene erste Schaltelement (M1, M2) in der ersten Vollbrücke (1) zu öffnen, ein zweites Schaltelement (M3, M4) in der ersten Vollbrücke (1) zu schließen und ein fehlerhaftes erstes Schaltelement (M1, M2) detektieren, falls die elektrische Spannung über dem ersten Kondensator (C1) innerhalb einer vorbestimmten zweiten Zeitspanne nach dem Schließen des zweiten Schaltelements (M3, M4) um mehr als einen vorgegebenen zweiten Spannungswert absinkt,
**dadurch gekennzeichnet,**
**dass** die Steuereinrichtung (7) dazu ausgelegt ist, die zweite Vollbrücke (2) zum Aufladen des Kondensators (C1) derart anzusteuern, dass an der Sekundärseite des Transformators (3) eine Wechselspannung bereitgestellt wird und dass eine daraufhin an der Primärseite des Transformators (3) induzierte Wechselspannung über die parallel zu den Schaltelementen (M1.. M4) der ersten Vollbrücke (1) angeordneten Dioden gleichgerichtet wird und den ersten Kondensator (C1) auflädt.

8. Spannungsversorgungseinrichtung für ein Elektro- oder Hybridfahrzeugs, mit:
einem Hochvolt-Bordnetz, das dazu ausgelegt ist, elektrische Energie mit einer ersten vorbestimmten elektrischen Spannung bereitzustellen;
einem Niedervolt-Bordnetz, das dazu ausgelegt ist, elektrische Energie mit einer zweiten vorbestimmten elektrischen Spannung bereitzustellen;
einem Gleichspannungskonverter nach Anspruch 7, wobei der erste Gleichspannungsanschluss (10) des Gleichspannungskonverters mit dem Hochvolt-Bordnetz elektrisch koppelbar ist, und der zweite Gleichspannungsanschluss (20) des Gleichspannungskonverters elektrisch mit dem Niedervolt-Bordnetz gekoppelt ist.

## Claims

1. Diagnostic method for a bidirectional DC-to-DC voltage converter that comprises a first capacitor (C1) and a first full bridge (1) at a first DC voltage terminal (10) and that comprises a second full bridge (2) at a second DC voltage terminal (20), wherein the first full bridge (1) comprises two half bridges (11, 12) each having a first switching element (M1, M2) and a second switching element (M3, M4),
wherein the first DC voltage terminal (10) is decoupled from other electrical consumers,
wherein the DC-to-DC voltage converter comprises a transformer (3) that is electrically coupled to the first full bridge (1) at a primary side and is electrically coupled to the second full bridge (2) at a secondary side,
comprising the steps of:
providing (S1) a first DC voltage at the second DC voltage terminal (20) of the DC-to-DC voltage converter;
opening (S2) the first switching elements (M1, M2) and the second switching elements (M3, M4) in the first full bridge (1);
charging (S3) the first capacitor (C1) to a predetermined first test voltage by driving the second full bridge (2);
closing (S4) a first switching element (M1, M2) in the first full bridge (1);
detecting (S5) a faulty second switching element (M3, M4) if the electric voltage across the first capacitor (C1) drops by more than a predefined first voltage value within a predetermined first time interval following the closure of the first switching element (M1, M2);
opening (S6) the closed first switching element (M1, M2) in the first full bridge (1);
closing (S7) a second switching element (M3, M4) in the first full bridge (1); and
detecting (S8) a faulty first switching element (M1, M2) if the electric voltage across the first capacitor (C1) drops by more than a predefined second voltage value within a predetermined second time interval following the closure of the second switching element (M3, M4),
**characterized**
**in that** the second full bridge (2), in order to charge (S3) the capacitor (C1), is driven such that an AC voltage is provided at the secondary side of the transformer (3) and that an AC voltage thereby induced at the primary side of the transformer (3) across the diodes arranged in parallel with the switching elements (M1... M4) of the first full bridge (1) is rectified and charges the first capacitor (C1).

2. Diagnostic method according to Claim 1, wherein the steps of opening (S6) the closed first switching element (M1, M2), of closing (S7) the second switching element (M3, M4) and of detecting (S8) a faulty first switching element (M1, M2) are performed only if no faulty second switching element (M3, M4) has been detected.

3. Diagnostic method according to Claim 1 or 2, comprising a step of charging the first capacitor (C1) to a predetermined second test voltage after the closed first switching element (M1, M2) has been opened.

4. Diagnostic method according to one of Claims 1 to 3, wherein the predetermined first voltage and/or the predetermined second voltage to which the first capacitor (C1) is charged is determined depending on a maximum forward current, a maximum operating temperature and/or a maximum heat dissipation of the first switching elements (M1, M2) and/or of the second switching elements (M3, M4) in the first full bridge (1).

5. Diagnostic method according to one of Claims 1 to 4, wherein the value of the first test voltage to which the first capacitor (C1) is charged is greater than the value of the first DC voltage that is provided at the second DC voltage terminal (20).

6. Diagnostic method according to one of Claims 1 to 5, comprising a step of activating the DC-to-DC voltage converter if no faulty first switching element (M1, M2) and no faulty second switching element (M3, M4) has been detected.

7. DC-to-DC voltage converter for a bidirectional DC-to-DC voltage conversion between a first DC voltage terminal (10) and a second DC voltage terminal (20), having:
a transformer (3) that is electrically coupled to the first full bridge (1) at a primary side and is electrically coupled to the second full bridge (2) at a secondary side;
a first capacitor (C1) that is electrically coupled to the first DC voltage terminal (10);
wherein the first DC voltage terminal (10) is decoupled from other electrical consumers;
a first full bridge (1) that is electrically coupled to the first DC voltage terminal (10) and that comprises two half bridges (11, 12) each having a first switching element (M1, M2) and a second switching element (M3, M4);
a second full bridge (2) that is electrically coupled to the second DC voltage terminal (20); and
a controller (7) that is designed to open the first switching elements (M1, M2) and the second switching elements (M3, M4) of the first full bridge (1), to charge the first capacitor (C1) by driving the second full bridge (2) at a predetermined first test voltage, to then close one of the first switching elements (M1, M2) in the first full bridge (1) and to detect a faulty second switching element (M3, M4) in the first full bridge (1) if the electric voltage across the first capacitor (C1) drops by more than a predefined first voltage value within a predetermined first time interval following the closure of the first switching element (M1, M2), to then open the closed first switching element (M1, M2) in the first full bridge (1), to close a second switching element (M3, M4) in the first full bridge (1) and detect a faulty first switching element (M1, M2) if the electric voltage across the first capacitor (C1) drops by more than a predefined second voltage value within a predetermined second time interval following the closure of the second switching element (M3, M4) **characterized**
**in that** the controller (7) is designed to drive the second full bridge (2), in order to charge the capacitor (C1), such that an AC voltage is provided at the secondary side of the transformer (3) and that an AC voltage thereby induced at the primary side of the transformer (3) across the diodes arranged in parallel with the switching elements (M1... M4) of the first full bridge (1) is rectified and charges the first capacitor (C1).

8. Voltage supply device for an electric or hybrid vehicle having:
a high-voltage on-board system that is designed to provide electrical energy at a first predetermined electric voltage;
a low-voltage on-board system that is designed to provide electrical energy at a second predetermined electric voltage;
a DC-to-DC voltage converter according to Claim 7, wherein the first DC voltage terminal (10) of the DC-to-DC voltage converter is able to be electrically coupled to the high-voltage on-board system, and the second DC voltage terminal (20) of the DC-to-DC voltage converter is electrically coupled to the low-voltage on-board system.

## Revendications

1. Procédé de diagnostic pour un convertisseur de tension continue bidirectionnel qui comprend un premier condensateur (C1) et un premier pont complet (1) à une première borne de tension continue (10) et qui comprend un deuxième pont complet (2) à une deuxième borne de tension continue (20), le premier pont complet (1) comprenant deux demi-ponts (11, 12) pourvus chacun d'un premier élément de commutation (M1, M2) et d'un deuxième élément de commutation (M3, M4),
la première borne de tension continue (10) étant découplée d'autres consommateurs électriques,
le convertisseur de tension continue comprenant un transformateur (3) qui est couplé électriquement au premier pont complet (1) par un côté primaire et couplé électriquement au deuxième pont complet (2) par un côté secondaire,
le procédé comprenant les étapes suivantes :
fournir (S1) une première tension continue au niveau de la deuxième borne de tension continue (20) du convertisseur de tension continue ;
ouvrir (S2) les premiers éléments de commutation (M1, M2) et les deuxièmes éléments de commutation (M3, M4) dans le premier pont complet (1) ;
charger (S3) le premier condensateur (C1) à une première tension de test prédéterminée par excitation du deuxième pont complet (2) ;
fermer (S4) un premier élément de commutation (M1, M2) dans le premier pont complet (1) ;
détecter (S5) un deuxième élément de commutation défectueux (M3, M4) si la tension électrique aux bornes du premier condensateur (C1) chute de plus d'une première valeur de tension prédéfinie dans un premier intervalle de temps prédéterminé après la fermeture du premier élément de commutation (M1, M2) ;
ouvrir (S6) le premier élément de commutation fermé (M1, M2) dans le premier pont complet (1) ;
fermer (S7) un deuxième élément de commutation (M3, M4) dans le premier pont complet (1) ; et
détecter (S8) un premier élément de commutation (M1, M2) défectueux si la tension électrique aux bornes du premier condensateur (C1) chute de plus d'une deuxième valeur de tension prédéfinie dans un deuxième intervalle de temps prédéterminé après la fermeture du deuxième élément de commutation (M3, M4),
**caractérisé en ce que**
pour charger (S3) le condensateur (C1) le deuxième pont complet (2) est excité de manière à ce qu'une tension alternative soit fournie sur le côté secondaire du transformateur (3) et à ce qu'une tension alternative alors induite sur le côté primaire du transformateur (3) soit redressée par les diodes disposées parallèlement aux éléments de commutation (M1... M4) du premier pont complet (1) et charge le premier condensateur (C1).

2. Procédé de diagnostic selon la revendication 1, les étapes d'ouverture (S6) du premier élément de commutation fermé (M1, M2), de fermeture (S7) du deuxième élément de commutation (M3, M4) et de détection (S8) d'un premier élément de commutation (M1, M2) défectueux ne peuvent être réalisées que si aucun deuxième élément de commutation (M3, M4) défectueux n'a été détecté.

3. Procédé de diagnostic selon la revendication 1 ou 2, comprenant une étape de charge du premier condensateur (C1) à une deuxième tension de test prédéterminée après ouverture du premier élément de commutation fermé (M1, M2).

4. Procédé de diagnostic selon l'une des revendications 1 à 3, la première tension prédéterminée et/ou la deuxième tension prédéterminée, à laquelle le premier condensateur (C1) est chargé, étant déterminées en fonction d'un courant direct maximal, d'une température de fonctionnement maximale et/ou d'une dissipation thermique maximale des premiers éléments de commutation (M1, M2) et/ou des deuxièmes éléments de commutation (M3, M4) du premier pont complet (1).

5. Procédé de diagnostic selon l'une des revendications 1 à 4, la valeur de la première tension de test, à laquelle le premier condensateur (C1) est chargé, est supérieure à la valeur de la première tension continue qui est fournie au niveau de la deuxième borne de tension continue (20).

6. Procédé de diagnostic selon l'une des revendications 1 à 5, comprenant une étape de validation du convertisseur de tension continue si aucun premier élément de commutation (M1, M2) défectueux et aucun deuxième élément de commutation (M3, M4) défectueux n'ont été détectés.

7. Convertisseur de tension continue, destiné à la conversion de tension continue bidirectionnelle entre une première borne de tension continue (10) et une deuxième borne de tension continue (20), ledit convertisseur comprenant :
un transformateur (3) qui est couplé électriquement au premier pont complet (1) par un côté primaire et couplé électriquement au deuxième pont complet (2) par un côté secondaire ;
un premier condensateur (C1) qui est couplé électriquement à la première borne de tension continue (10), la première borne de tension continue (10) étant découplée d'autres consommateurs électriques ;
un premier pont complet (1) qui est couplé électriquement à la première borne de tension continue (10) et qui comprend deux demi-ponts (11, 12) pourvus chacun d'un premier élément de commutation (M1, M2) et d'un deuxième élément de commutation (M3, M4) ;
un deuxième pont complet (2) qui est couplé électriquement à la deuxième borne de tension continue (20) ; et
un dispositif de commande (7) qui est conçu pour ouvrir les premiers éléments de commutation (M1, M2) et les deuxièmes éléments de commutation (M3, M4) du premier pont complet (1), charger le premier condensateur (C1) à une première tension de test prédéterminée en excitant le deuxième pont complet (2), puis fermer l'un des premiers éléments de commutation (M1, M2) du premier pont complet (1) et détecter un deuxième élément de commutation (M3, M4) défectueux dans le premier pont complet (1) si la tension électrique aux bornes du premier condensateur (C1) chute de plus d'une première valeur de tension prédéfinie dans un premier intervalle de temps prédéterminé après la fermeture du premier élément de commutation (M1, M2), puis ouvrir le premier élément de commutation fermé (M1, M2) dans le premier pont complet (1), fermer un deuxième élément de commutation (M3, M4) dans le premier pont complet (1) et détecter un premier élément de commutation (M1, M2) défectueux si la tension électrique aux bornes du premier condensateur (C1) chute de plus d'une deuxième valeur de tension prédéfinie dans un deuxième intervalle de temps prédéterminé après la fermeture du deuxième élément de commutation (M3, M4),
**caractérisé en ce que**
le dispositif de commande (7) est conçu pour exciter, afin de charger le condensateur (C1), le deuxième pont complet (2) de manière à ce qu'une tension alternative soit fournie sur le côté secondaire du transformateur (3) et qu'une tension alternative alors induite sur le côté primaire du transformateur (3) soit redressée par les diodes disposées parallèlement aux les éléments de commutation (M1... M4) du premier pont complet (1) et charge le premier condensateur (C1).

8. Dispositif d'alimentation en tension d'un véhicule électrique ou hybride, ledit dispositif comprenant :
un réseau de bord à haute tension qui est conçu pour fournir de l'énergie électrique avec une première tension électrique prédéterminée ;
un réseau de bord à basse tension qui est conçu pour fournir de l'énergie électrique avec une deuxième tension électrique prédéterminée ;
un convertisseur de tension continue selon la revendication 7, la première borne de tension continue (10) du convertisseur de tension continue pouvant être couplée électriquement au réseau de bord à haute tension, et la deuxième borne de tension continue (20) du convertisseur de tension continue étant couplée électriquement au réseau de bord à basse tension.
